# EUROPÄISCHE PATENTANMELDUNG

(11) **EP 2 964 004 A2**
(43) Veröffentlichungstag der Anmeldung: **06.01.2016**
(21) Anmeldenummer: 15001912.3
(22) Anmeldetag: 29.06.2015
(51) Int. Cl.: H05K 1/02, H05K 1/14

(54) **ELEKTRONISCHE BAUTEILANORDNUNG**

(30) Priorität: 04.07.2014 DE 102014109385
(71) Anmelder: Karlsruher Institut für Technologie, 76131 Karlsruhe (DE)
(72) Erfinder: Meißer, Michael, 76137 Karlsruhe (DE); Blank, Thomas, 76187 Karlsruhe (DE)

(57) **Zusammenfassung**

Die vorliegende Erfindung stellt eine elektronische Bauteilanordnung mit einem Leistungselektronikmodul (2) und einem übergeordneten Schaltungsträger (3) bereit. Dabei weist das Leistungselektronikmodul zumindest eine elektrisch leitende Lage (4) und der übergeordnete Schaltungsträger zumindest eine weitere elektrisch leitende Lage (5) als Oberflächenstruktur auf. Erfindungsgemäß sind das Leistungselektronikmodul und der übergeordnete Schaltungsträger durch zumindest ein plattenförmiges Verbindungselement (6) miteinander elektrisch und mechanisch verbunden, wobei das zumindest eine Verbindungselement zumindest eine elektrisch leitende Lage (7) als Oberflächenstruktur aufweist, die mit der zumindest einen elektrisch leitenden Lage des Leistungselektronikmodus und der zumindest einen elektrisch leitenden Lage des übergeordneten Schaltungsträgers elektrisch verbunden ist; und wobei das Verbindungselement zumindest einen Kondensator (6b) mit einer nicht leitenden Oberfläche aufweist, die die zumindest eine elektrisch leitende Lage trägt.

## Beschreibung

Die Erfindung betrifft eine elektronische Bauteilanordnung mit einem Leistungselektronikmodul und einem übergeordneten Schaltungsträger.

Aus dem Stand der Technik sind Leistungselektronikmodule mit integrierten elektronischen Bauteilen bekannt, die aus einem Hauptsubstrat, einem Direct-Copper-Bond-Substrat, kurz DCB-Substrat, und aufgelöteten Leistungshalbleiterchips sowie einer elektrischen Verbindungstruktur aufgebaut sind. Derartige Module finden Anwendung insbesondere im Bereich der Elektromobilität, der erneuerbaren Energien und der Industrieautomatisierung. Allerdings weisen bisherige Leistungselektronikmodule einen vergleichsweise geringen Integrationsgrad auf, wobei Gatetreiber und Zwischenkreiskondensatoren zumeist nicht in die Module integriert sind. Auch ist das Hauptsubstrat des Leistungelektronikmoduls lediglich mit groben (900µm pitch) Strukturen versehen, die den Leistungskreis abbilden. Gate- und Source-Anschlüsse der Leistungshalbleiterchips werden über Bondkontakte auf elektrische Verbindungstrukturen, zumeist Steck- oder Schraubanschlüsse geführt. Die elektrische Verbindung der außerhalb des Moduls angeordneten Zwischenkreiskondensatoren und Gatetreiberschaltungen erfolgt über Anschlusssysteme, die eine typische Leitungslänge im Bereich von Zentimetern und einen Abstand zueinander von mehreren Millimetern aufweisen, wie u. a. in DE 10 191 585 B4 und Zheng, C., Y. Yiying, et al. "A 1200-V, 60-A SiC MOSFET Multichip Phase-Leg Module for High-Temperature, High-Frequency Applications", IEEE Transactions on Power Electronics 29(5), 2307-2320 (2014) offenbart ist.

Aufgrund der Bauweise zeigt sich oft eine hohe, in den meisten Fällen ungewollte und daher parasitäre Induktivität der das Modul verlassenden Verbindungstruktur. Der dabei entstehende aus parasitären Induktivitäten und Kapazitäten aufgebaute Schwingkreis kann störende Spannungsschwingungen erzeugen, die den Halbleiterbauteilen schaden können und Signalübertragungseigenschaften sowie eine elektromagnetische Verträglichkeit der Bauteile im Modul verschlechtern.

Zwar sind niederinduktive Leitungsführungen nach Bayerer, R. et al., "Power circuit design for clean switching", Integrated Power Electronics Systems (CIPS), 2010, bekannt, wobei sich zwei Kontaktgruppen (DC+ und DC-) im Abstand von einigen Millimetern gegenüber stehen und so eine planare Leitungsführung ermöglichen. Durch eine hohe Zahl an Kontakten und der dadurch entstehenden flächenhaften Kontaktausbildung können parasitäre Induktivitäten zwar reduziert werden. Allerdings werden die elektrischen Potentiale nicht durchgehend durch Festkörper isoliert, da die Isolation unterhalb eines mit dem Modul zu kontaktierenden Schaltungsträgers endet. Durch die in diesem Bereich nötige Isolation mit dem Medium Luft müssen sehr große Sicherheitsabstände eingehalten werden, um elektrische Überschläge zu verhindern. Die durch den großen Abstand der Leiter hervorgerufene große Stromschleifenfläche begrenzt die minimal mögliche parasitäre Induktivität. Der große Leiterabstand wird auch.durch die nur bedingt belastbare Isolation durch die das Modul versiegelnde Vergussmasse, zumeist eine Silikonvergussmasse, sowie durch deren geringe mechanische Belastbarkeit bedingt. Ohne Verringerung des Leiterabstands und Einfügen einer Schicht mit einer großen Dieektrizitätskonstanten und einer großen Spannungsfestigkeit bleibt die parasitäre Induktivität der Verbindungsstruktur auf Werte im in der Regel zweistelligen Nanohenry-Bereich begrenzt.

Bei Verwendung von Leiterplattensubstraten aus organischen Materialien als Verbindung zwischen dem Substrat eines Leistungselektronikmoduls und einem übergeordneten Schaltungsträger wie in Frisch, M. et al. "Power module with additional low inductive current path", Integrated Power Electronics Systems (CIPS), 2010, beschrieben, wird die Verbindung zum Schaltungsträger durch eine Fingerstruktur hergestellt, die eine zuvor geschaffene, koplanare Struktur der Leiterplatte durchbricht. Auch hier entstehen parasitäre Induktivitäten.

Aus der DE 10 333 315 B4 ist eine Stromzuführung bekannt, die auf einem Substrat ausgebildet ist, das rechtwinklig zu einem Hauptsubstrat und anderen Stromleitern angeordnet ist, um eine magnetische Kopplung zu minimieren. Es sind breite, kurze Leiterstrukturen sowie Leitungen verschiedener elektrischer Potentiale auf beiden Seiten des senkrecht stehenden Substrates offenbart. Zur Wahrung des notwendigen Schutzabstandes, um einen elektrischen Überschlag zu vermeiden, endet das normal zum Hauptsubstrat angeordnete Substrat kurz oberhalb der Oberfläche des Hauptsubstrats, wobei beide Metallisierungen des senkrechten Substrates nicht bis auf das Hauptsubstrat geführt sind. Diese Stromzuführung ist demnach nicht für die niederinduktive Versorgung eines Leistungselektronikmoduls geeignet, da ein Rückleiter fehlt. In einer Ausgestaltungsform gibt DE 10 333 315 B4 eine Stromzuführung bekannt, die einen unterhalb des Hauptsubstrates des Leistungselektronikmoduls befindliche leitende Struktur bedingt. Diese ist bei technischen Anwendungen stets mit der Masse des Kühlkörpers verbunden und darf aus Gründen der elektromagnetischen Verträglichkeit nicht mit Potentialen aus dem Inneren des Moduls verbunden werden.

Die US 5 031 069 A offenbart einen Modulrahmen, der um ein Leistungselektronikmodul umlaufend ausgebildet ist. Der Modulrahmen wird als Schichtkondensator genutzt, wobei eine Seite des Schichtkondensators an einer Innenseite und die andere Seite des Schichtkondensators an einer Außenseite über einen Moduldeckel kontaktiert wird. Eine Integration weiterer Kondensatoren bzw. weiterer Komponenten ist allerdings nicht möglich.

Aus der DE 10 2007 00 523 ist ein leistungselektronisches Steckkartensystem mit Flüssigkühlung bekannt. Die Kontaktierung liegt zwischen einem äußeren Steckverbinder und einem Hauptsubstrat eines Leistungselektronikmoduls in der Ebene des Hauptsubstrates, wobei das Hauptsubstrat koplanar ausgebildet ist. Diese Anordnung wird für Systeme mit doppelseitiger Flüssigkühlung genutzt, welche aufgrund der nötigen Dichtungen und der erschwerten Montage sehr aufwändig und inkompatibel zum gegenwärtigen Standard der einseitigen Kühlung ist.

Die DE 69 414 337 T2 beschreibt eine koaxiale Verbindungsstruktur zwischen elektronischen Bauteilkomponenten, bei der mehrere Leistungshalbleiter im Kreis angeordnet sind. Da keine durchgehende Isolierung vorliegt, kann es bei dieser Anordnung der Bauteilkomponenten zu Teilentladungen kommen.

Nachteilig am vorgenannten Stand der Technik ist insbesondere, dass eine Hochfrequenztrennung zwischen Modul und Außenwelt durch hohen Induktivitätsbelag der elektrischen Verbindung, insbesondere der Gleichspannungsversorgungsverbindung (DC-Bus) auftreten kann. Auch ergeben sich Schwierigkeiten, niederinduktive Verbindungen koplanar über Entfernungen im Zentimeterbereich und sich ändernde Richtungen, wie z.B. 90°-Bögen, zu den Zwischenkreiskondensatoren zu führen, wenn hohe Spannungen isoliert werden müssen und das Modul mit hoher Betriebsfrequenz arbeiten soll.

Diese erhöhten Induktivitätsbeläge ziehen sowohl im Leistungs- wie auch im Gatetreiberkreis parasitäre Resonanzen und eine Begrenzung der maximalen Schaltgeschwindigkeit nach sich. Die maximale Schaltgeschwindigkeit, die von z.B. SiC Leistungshalbleiterchips geboten wird, kann somit nicht ausgeschöpft werden. Die räumlichen Ausdehnungen des Leistungskreises und des Gatetreiberkreises führen auch zu erhöhter elektromagnetischer Emission (EMI), welche den Kostenaufwand für Schirmmaßnahmen erhöht.

Die Module weisen durch getrennte, diskrete Bauteile für Stromzuführung und Energiespeicherung eine große räumliche Ausdehnung auf und werden dadurch groß und unhandlich.

Ausgehend von diesem Stand der Technik ist es **Aufgabe der vorliegenden Erfindung,** eine verbesserte elektronische Bauteilanordnung bereitzustellen, die neben geringeren parasitären Induktivitäten die Leistung der verwendeten Leistungshalbleiterchips ausschöpfen kann und zudem eine höhere Integration von elektronischen Komponenten ermöglicht.

Diese Aufgabe wird durch eine elektronische Bauteilanordnung mit den Merkmalen des Anspruchs 1 gelöst.

Weiterbildungen und bevorzugte Ausführungsformen der elektronischen Bauteilanordnung sind in den Unteransprüchen ausgeführt.

Eine Ausführungsform bezieht sich auf eine elektronische Bauteilanordnung mit einem Leistungselektronikmodul und einem übergeordneten Schaltungsträger. Dabei weist das Leistungselektronikmodul eine oder mehrere elektrisch leitende Lage(n), und der übergeordnete Schaltungsträger eine oder mehrere elektrisch leitende Lage(n) als Oberflächenstruktur auf. Erfindungsgemäß sind das Leistungselektronikmodul und der übergeordnete Schaltungsträger durch wenigstens ein plattenförmiges Verbindungselement miteinander elektrisch und mechanisch verbunden, wobei das zumindest eine Verbindungselement eine oder mehrere elektrisch leitende Lage(n) als Oberflächenstruktur aufweist, die mit der einen oder den mehreren elektrisch leitenden Lage(n) des Leistungselektronikmoduls und der einen oder den mehreren elektrisch leitenden Lage(n) des übergeordneten Schaltungsträgers elektrisch verbunden ist/sind. Die elektrisch leitenden Lagen sind durch zumindest einen elektrischen Isolatorfestkörper voneinander elektrisch isoliert.

Der übergeordnete Schaltungsträger kann jede Art von elektronischen Bauteilen, insbesondere Zwischenkreiskondensatoren oder Leiterstrukturen, aufweisen, so dass diese Komponente der Bauteilanordnung je nach Anwendung flexibel bestückt werden kann.

Ein plattenförmiges Verbindungselement bedeutet hierbei, dass ein oder mehrere Abschnitte des Verbindungselements eine Abmessung normal zur Längsachse der Verbindungsstruktur aufweisen, die sehr viel kleiner ist als eine Höhe und eine Breite der Verbindungsstruktur. Dadurch kann die Fläche zwischen elektrisch leitenden Lagen, die in der Regel auf unterschiedlichen Potentialen liegen, so klein wie möglich gestaltet werden und parasitäre Induktivitäten effektiv minimiert werden.

Dabei ist erfindungsgemäß vorgesehen, dass das Verbindungselement mehrere elektrisch leitende Lagen aufweist, die voneinander elektrisch isoliert sind. Dadurch kann eine Oberflächenstruktur auf dem Verbindungselement zur optimalen Stromzuführung und Signalleitung realisiert werden. Bisher musste eine Stromführung zwischen übereinander angeordneten Schaltungsträgern über Steckkontakte erfolgen, die üblicherweise große Abmessungen im Vergleich zu den Abmessungen der elektronischen Komponenten haben. Durch die erfindungsgemäße mechanische und elektrische Verbindung, insbesondere durch die Integration von Kondensatoren in die Verbindungsstruktur wird weniger Platz auf dem Modulsubstrat benötigt, welcher für weitere Leitungen oder auch zur Anbindung von weiteren Komponenten genutzt werden kann.

Die Erfindung kann vorsehen, dass das Verbindungselement eine oder mehrere Lage(n) aus einem organischen oder vorzugsweise keramischen Substrat als Isolator und/oder Dielektrikum aufweist, bspw. Aluminiumnitrid, Aluminiumoxid oder Siliziumnitrid etc. Ferner sind Kunststoffe (z.B. Kapton) oder auch Faserverbundwerkstoffe (z.B. FR4) denkbar Diese sind elektrisch nichtleitend, was im Sinne der Erfindung heißt, dass die Leitfähigkeit unter einem bestimmten sehr niedrig angesetzten Grenzwert liegt, so dass die Leitfähigkeit insgesamt nahe bei Null ist. Durch die Verwendung eines Leiterplattensubstrats kann der Übergang und die Stromzuführung zwischen Leistungselektronikmodul und dem übergeordneten Schaltungsträger dünner und belastbarer gestaltet werden. Die Abstände der Komponenten zueinander können verkleinert werden und ermöglichen eine höhere Integration, auch von weiteren elektronischen Bauteilen. Sowohl das Leistungselektronikmodul als auch der übergeordnete Schaltungsträger können jeweils zumindest ein elektrisch nicht-leitendes Substratmaterial aufweisen, wie auch das Substratmaterial des Verbindungselements.

Dabei kann das Verbindungselement in einer weiteren Ausführungsform aus mehreren Teilen bestehen, die mechanisch und auch elektrisch miteinander verbunden sein können. Die Teile können dabei normal zu einer Längsachse des Verbindungselements angeordnet sein und vorhandenen Leiterstrukturen auf dem Leistungselektronikmodul angepasst werden. Dazu kann das Verbindungselement auch Ausnehmungen aufweisen, die vorbestimmte Bereiche, Abschnitte oder Aufbauten, wie aufgesetzte elektronische Bauteile, auf dem Leistungselektronikmodul überbrücken. Der genauen Anordnung und Ausgestaltung des Verbindungselements sind dabei keine Grenzen gesetzt. Zudem kann durch das Verbindungselement vorteilhaft erreicht werden, dass Druck- bzw. Spannungsverteilung innerhalb der Bauteilanordnung verbessert werden, da die Leiterplatten bzw. Substrate der Komponenten aufgrund des Rahmens nicht nur an den Seiten unter Spannung gesetzt werden, sondern auch ein Gegendruck innerhalb der Flächen der Komponenten erzeugt werden kann. Dadurch kann eine Druckentlastung der Seitenränder und eine insgesamt stabilere Anordnung erzeugt werden.

In einer Weiterbildung kann das Verbindungselement bevorzugt eine Lage aus einem organischen oder keramischen Substrat aufweisen, welches mit mindestens einer elektrisch leitfähigen Schicht versehen ist. Das keramische Substrat kann vorteilhaft aus einem magnetisch leitfähigen Material, bevorzugt aus MnZn oder NiZn-Ferrit bestehen, und abschnittsweise oder auch teilweise oder vollständig mit diesem magnetisch leitfähigen Material ummantelt sein. Die Verbindungsstruktur kann als Ausgangsfilter mit mindestens einer magnetischen Filterkomponente dienen. Durch die Integration des Ausgangsfilters in die Verbindungsstruktur wird Platz gespart und die elektromagnetische Abstrahlung reduziert.

Alternativ kann das Verbindungselement zwei oder mehrere Lagen aus einem organischen oder keramischen Substrat, bevorzugt Lagen aus einem keramischen Substrat aufweisen, wobei zwischen zumindest zwei der zwei oder mehreren Lagen eine elektrisch leitfähige Lage, bevorzugt eine Metalllage angeordnet ist. So können Zwischenstrukturen oder elektrisch abgeschirmte Lagenstrukturen gebildet werden. Ein mehrlagiger Aufbau des Verbindungselements kann auch als integrierter Kondensator dienen, wenn das Verbindungselement basierend auf einem keramischen Substrat mit durch Dickschichttechnik im Wechsel dünne (10-150 µm) leitende und nicht-leitende Lagen bestückt ist, wobei die leitenden Lagen mit unterschiedlichen elektrischen Potentialen verbunden werden können. Durch den geringeren Abstand der elektrisch leitenden Lagen zueinander, wird eine Kapazität erzeugt, die mit jeder zusätzlichen Lage erhöht werden kann. Erfindungsgemäß ist unter einem mehrlagigen Aufbau des Verbindungselements eine Schichtstruktur zu verstehen, die aus mindestens 2 elektrisch leitenden Lagen mit unterschiedlichen elektrischen Potentialen besteht, wobei in einer bevorzugten Ausführungsform die Lagenanzahl 2 bis 200 beträgt und in einer besonders bevorzugten Ausführungsform die Lagenanzahl 4 bis 50 beträgt. Das Verbindungselement stellt somit nicht nur die elektrische Verbindung verschiedener Potentiale des Leistungselektronikmoduls mit dem übergeordneten Schaltungsträger dar. Darüber hinaus vereint es zumindest Teile des notwendigen Zwischenkreiskondensators. Dadurch wird Platz auf dem Hauptsubstrat des Leistungselektronikmoduls gespart und die Induktivität der Verbindungsstruktur reduziert.

Durch thermische und mechanische Belastung können Risse in der Trägerstruktur des Verbindungselements auftreten, die zu Durchschlägen führen können. Werden flexible Übergänge (z.B. aus Polymerverbindungen) zwischen den elektrisch leitenden Lagen, zwischen elektrisch leitenden Lagen und dem jeweiligen Substrat oder zwischen verschiedenen Substraten, bspw. von Leistungselektronikmodul und den elektrisch leitfähigen Lagen des Verbindungselements verwendet, was hiermit vorgeschlagen wird, können diese Risse vermieden werden.

In einer weiteren bevorzugten Weiterbildung kann das Verbindungselement einen oder mehrere Kondensator(en) mit einer nichtleitenden Oberfläche aufweisen, die die eine oder mehreren elektrisch leitenden Lage(n) trägt/tragen. Sie können zu mehreren aufeinandergestapelt werden, sodass durch diesen Aufbau eine Trägerstruktur für das Verbindungselement entsteht, wobei diese mit zumindest zwei elektrisch leitenden Lagen des Verbindungselements elektrisch leitend verbunden sein kann. Die Kondensatoren können dabei mit ihrer flachen Seite zueinander oder 90° verdreht zueinander gestapelt werden und damit parallel oder normal zu einer Längsachse des Verbindungselements angeordnet sein. Neben Plattenkondensatoren können auch Rollkondensatoren oder andere Kondensatorstrukturen eingesetzt werden, so z.B. Multilagenkondensatoren, die in Reihe oder parallel geschaltet sein können. Damit kann neben der elektrischen Verbindung des Moduls mit dem übergeordneten Schaltungsträger auch eine Kurzzeitspeicherung elektrischer Energie erreicht werden bzw. diese Kondensatoren in die Bauteilanordnung platzsparend integriert werden.

Zum Schutz der empfindlichen elektrisch leitenden Lagen bzw. weiterer elektronischer Bauteile kann die zumindest eine elektrisch leitende Lage des Leistungselektronikmoduls bzw. eben die auf einem Hauptsubstrat des Leistungselektronikmoduls angeordneten elektronischen Komponenten ganz oder teilweise in eine Vergussmasse (z.B. Epoxidharz, Silikonvergussmasse) eingegossen werden. Dabei kann ein Abschnitt des Verbindungselements aus der Vergussmasse herausragen. Durch den erfindungsgemäßen Aufbau kann das Verbindungselement nach Bestücken des Leistungselektronikmoduls und dessen vollständiger Kontaktierung durch Drahtbonden, Sintern oder Löten auf das Modul aufgebracht werden und das Modul einfach vergossen werden. Die empfindlichen Anordnungen auf dem Modul werden effektiv vor Umwelteinflüssen geschützt und das Verbindungselement zusätzlich stabilisiert.

Alternativ kann vorgesehen sein, dass das Substrat des Verbindungselements eine oder mehrere Aussparung(en) freier Formgebung aufweist, die entlang einer Längsrichtung des Leistungselektronikmoduls in Richtung des übergeordneten Schaltungsträgers angeordnet ist. Damit können Abschnitte oder Bereiche des Leistungselektronikmoduls überbrückt werden und das Verbindungselement somit der Geometrie des Moduls angepasst werden.

Das Verbindungselement kann auch durch Kleben, Löten oder Verpressen mit dem Leistungselektronikmodul unlösbar verbunden sein. Es können Vertiefungen, Ausnehmungen oder Öffnungen in dem Substrat des Leistungselektronikmoduls vorgesehen sein, so dass ein zweiter Befestigungsabschnitt des Verbindungselements aufgenommen werden kann. Bevorzugt kann das Leistungselektronikmodul ein Hauptsubstrat aufweisen, das ein planares Keramiksubstrat ist, wobei die elektrisch leitende Lage bevorzugt eine Dickfilmlage, vorzugsweise hergestellt aus einer Kupfer- oder Silberpaste, ist. Auch kann das Verbindungselement ein Substrat aufweisen, das ein planares Keramiksubstrat ist, wobei die zwei oder mehr elektrisch leitenden Lagen bevorzugt Dickfilmlagen sein können. Weitere Isolationslagen können aus den in der Dickschichttechnik üblichen Isolationspasten hergestellt werden. Mit diesem Keramiksubstrat lassen sich die vorgenannten Verbindungsmöglichkeiten einfach realisieren. Das Substrat kann darüber hinaus auch aus einem DCB (direct copper bond) oder AMB (active metal brazed) Substrat bestehen.

Alternativ kann das Verbindungselement mit dem übergeordneten Schaltungsträger durch flexible Verbindungselemente, wie Federeinrichtungen oder Steckverbindungen lösbar oder durch Kleben, Löten oder Verpressen unlösbar verbunden werden. Dazu kann der übergeordnete Schaltungsträger eine Öffnung aufweisen, durch die ein erster Befestigungsabschnitt des Verbindungselements ragt und der mit den Rändern der Öffnung verbunden ist. Auch können Vertiefungen, Ausnehmungen, in die der erste Befestigungsabschnitt eingepasst werden kann, oder andere Befestigungsarten ermöglicht werden.

In einer bevorzugten Weiterbildung kann das Verbindungselement an beiden Enden zumindest jeweils einen lagenfreien Abschnitt aufweisen. Dieser dient dazu, die Lagen voneinander ausreichend zu isolieren, wobei eine Kriechstrecke vorbestimmter Länge gebildet wird. Die Länge der Kriechstrecke entspricht der für die sichere elektrische Isolation im jeweiligen umgebenden Medium notwendigen Kriechstrecke, in der Regel mehrere Millimeter.

Um die Komponenten der elektronischen Bauteilanordnung ausreichend zu schützen, kann diese einen Rahmen aufweisen, der eine oder mehrere der Komponenten des Leistungselektronikmoduls und des übergeordneter Schaltungsträgers oder alle Komponenten zusammen einrahmt. Erfindungsgemäß kann der Rahmen an seiner den zu umrahmenden Komponenten zugewandten Innenseite Halteeinrichtungen aufweisen, mit denen das Leistungselektronikmodul, der übergeordnete Schaltungsträger und das Verbindungselement selbst bzw. einer der vorgenannten Komponenten in Eingriff stehen. Die Halteeinrichtungen können insbesondere Ausnehmungen oder Überstände sein.

Für eine geeignete Anordnung kann ferner vorgesehen sein, dass das plattenförmige Verbindungselement mit seiner Normalen senkrecht zur Normalen des Leistungselektronikmoduls angeordnet ist. Damit kann eine gute und möglichst kurze Verbindung der Komponenten untereinander erreicht werden.

Vorteilhaft können alle Ausführungsformen des erfindungsgemäßen Verbindungselements in Kombination mit einer anderen hier genannten Ausführungsform realisiert werden.

Weitere Ausführungsformen sowie einige der Vorteile, die mit diesen und weiteren Ausführungsformen verbunden sind, werden durch die nachfolgende ausführliche Beschreibung unter Bezug auf die begleitenden Figuren deutlich und besser verständlich. Die Figuren sind lediglich schematische Darstellungen einer Ausführungsform der Erfindung.

Dabei zeigen:
**Fig.1** eine Schnittansicht einer erfindungsgemäßen elektronischen Bauteilanordnung,
**Fig.2** eine Draufsicht auf ein erfindungsgemäßes Verbindungselement,
**Fig.3** eine Detailansicht eines ersten Befestigungsabschnitts des Verbindungselements,
**Fig.4a - 4d** Querschnittsansichten von verschiedenen Ausführungsformen des Verbindungselements,
**Fig.5a** - **5c** verschiedene Ansichten des Verbindungselements mit einer Kondensatoranordnung als Trägerelement,
**Fig.6a - 6b** Detailansichten alternativer erster Befestigungsabschnitte,
**Fig.7a** - **7b** verschiedene Detailansichten alternativer zweiter Befestigungsabschnitte, und
**Fig.8** eine perspektivische Ansicht einer weiteren Ausführungsform des Verbindungselements.

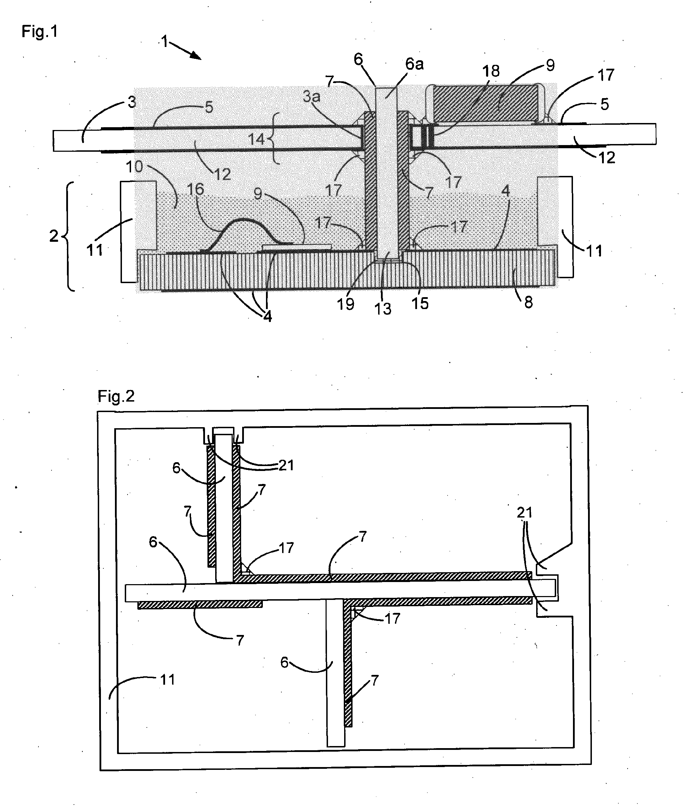

In **Fig.1** ist ein elektronisches Bauteil **1** gezeigt, das im Wesentlichen aus einem Leistungselektronikmodul **2** und einem übergeordneten Schaltungsträger **3** aufgebaut ist. Der übergeordnete Schaltungsträger **3** ist in **Fig.1** oberhalb des Leistungselektronikmoduls **2** angeordnet, wobei diese beiden Komponenten mit einem Verbindungselement **6** miteinander mechanisch und elektrisch in Verbindung stehen. Das Leistungselektronikmodul **2** weist ein Hauptsubstrat **8** auf, das auf seiner Oberseite und seiner Unterseite mit elektrisch leitfähigen Lagen **4** aus Metall (bspw. aus Kupfer oder einer Kupferlegierung) strukturiert ist. Dabei ist das Hauptsubstrat **8** des Leistungselektronikmoduls **2** als planare Keramikstruktur ausgebildet. Die leitfähigen Lagen **4** bilden planare Zuleitungsstrukturen zu unterschiedlichen Bereichen des Substrats **8.** Darauf sind verschiedene elektronische Komponenten **9** angeordnet, die u. a. über drahtförmige Zuleitungen **16** mit der elektrisch leitfähigen Lage **4** verbunden sind oder direkt mit der Lage **4** verlötet sind. Ferner ist das Leistungselektronikmodul **2** mit einem Rahmen **11** umgeben, der einerseits zum Schutz des Substrats **8** und der Komponenten **9** und andererseits zur Begrenzung des Leistungselektronikmoduls **2** und Einfassung einer Vergussmasse **10** dient, die ebenfalls zum Schutz der empfindlichen elektronischen Komponenten **9** und der Lage **4** dient.

Der übergeordnete Schaltungsträger **3** weist ebenfalls ein Substrat **12** auf und ist beidseitig mit elektrisch leitfähigen Lagen **5** aus Metall versehen. Auf diesen sind - hier auf einer Oberseite - weitere elektrische oder elektronische Komponenten **9,** bspw. ein Zwischenkreiskondensator, angeordnet und mit den Lagen **5** in entsprechender Weise kontaktiert. Zur elektrischen Verbindung von Komponenten oder leitenden Strukturen auf einer Unterseite des Schaltungsträgers **3** sind Durchkontaktierungen **18** vorgesehen, die durch das Substrat **12** hindurch die Lage **5** der Ober- und Unterseite des Substrats **12** kontaktieren.

Die Komponenten Leistungselektronikmodul **2,** übergeordneter Schaltungsträger **3** sowie Verbindungselement **6** sind untereinander über Lötnähte **17** mechanisch miteinander verbunden. Die Komponenten können aber auch miteinander verklebt oder verpresst und somit unlösbar miteinander verbunden sein. Die Lagen **4** auf dem Substrat **8** des Leistungselektronikmoduls **2** sind durch Lötnähte **17** als Lötverbindungen oder Pressung mit den leitfähigen Lagen **7** des Verbindungselements **6** verbunden. Gleiches gilt für die leitfähigen Lagen **5** des übergeordneten Schaltungsträgers **3.** So erfolgt durch das Verbindungselement 6 nicht nur eine mechanische, sondern auch eine elektrische Verbindung. Dabei ist eine Dicke des Verbindungselements **6** klein (in etwa 2-00-1000 µm) gegenüber einer Höhe (in etwa 5 mm - 20 mm) und einer Breite (in etwa 5 mm - 60 mm) desselben. Dies hat geringe parasitäre Induktivitäten zur Folge.

Das Verbindungselement 6 in **Fig.1** weist als Trägerelement ein Substrat **6a** aus einem flachen, keramischen elektrisch isolierenden Material mit beidseitiger elektrisch leitfähiger Lage **7** auf und bildet damit eine koplanare Struktur mit hohem kapazitivem und minimiertem induktivem Anteil. Das Verbindungselement **6** ist normal zum Substrat **8** des Leistungselektronikmoduls **2** angeordnet und verbindet mechanisch und elektrisch das Modul **2** mit dem übergeordneten Systemschaltungsträger **3**, indem es mindestens zwei verschiedene elektrische Potentiale, vorzugsweise + und -, des Leistungselektronikmoduls **2** mit Kontaktierungen **18** bzw. den Lagen **5** des übergeordneten Schaltungsträgers **3** verbindet.

Zur Befestigung des Verbindungselements **6** weist das Hauptsubstrat **8** eine Vertiefung bzw. Ausnehmung **15** auf, in die ein erster Befestigungsabschnitt **13** des Verbindungselements **6,** d. h. hier ein nicht beschichtetes, freies unteres Ende, aufgenommen ist. Das Substrat **6a** des Verbindungselements **6** ist hier freigestellt, um eine hohe Überschlagsfestigkeit bei Verguss, Verklebung oder Verlötung sowie bei altersbedingter Zerstörung dieser Verbindung zu ermöglichen. In der Ausnehmung ist eine Klebeschicht **19** eingelassen, die eine Klebeverbindung der beiden Substrate **8, 6a** herstellt.

Die **Fig.2** zeigt in Draufsicht eine mögliche Anordnung mehrerer Verbindungselemente **6,** die rechtwinklig zueinander in dem Rahmen **11** angeordnet sind. Dabei sind sie mechanisch bspw. durch Kleben und elektrisch über Lötverbindungen **17** miteinander verbunden. Der Rahmen **11** kann seitlich Halteeinrichtungen **21** aufweisen, die in Form von Auskragungen, Ausnehmungen, Überstände oder Klemmen die Verbindungselemente **6** innerhalb des Rahmens positionieren und festhalten. Die elektrisch leitfähigen Lagen **7** sind untereinander mit Lötnähten **17** kontaktiert und verbunden.

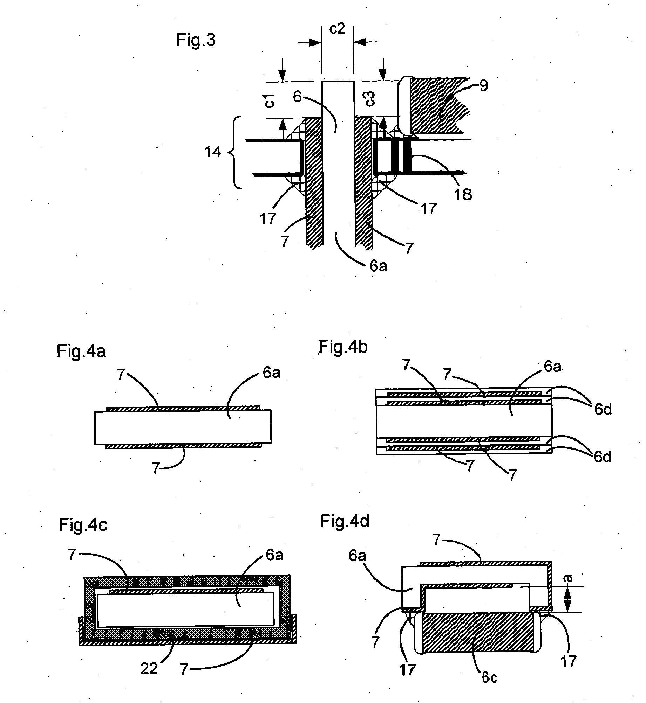

In **Fig.3** ist ein vergrößerter Ausschnitt aus **Fig.1** gezeigt, wobei das Substrat **6a** des Verbindungselements **6** eine Freistellung um seine Kanten eines freien Endes in einem zweiten Befestigungsabschnitt **14** aufweist. Es wird eine nicht beschichtete Kriechstrecke einer Länge c1 + c2 + c3 (Einzelstrecken c1, c2, c3) gebildet, sodass die Lagen **7** auf beiden Seitenflächen des Verbindungselements **6** elektrisch voneinander isoliert sind. Diese Kriechstrecke ist wichtig für die zu erreichende elektrische Überschlagsfestigkeit und vorrangig abhängig vom (keramischen) Material des Substrats 6a des Verbindungselements **6** sowie dessen Dicke c2. Die Strecke c1+c2+c3 ist in einem Bereich von in etwa 250 µm bis in etwa 15 mm lang, und bietet durch das nicht-leitende Substratmaterial **6a** eine ausreichend lange Kriechstrecke.

In den **Fig.4a** bis **4d** sind Querschnitte des Verbindungselements **6** gezeigt, wobei in **Fig.4a** die einfachste Ausführungsform eines Substrats **6a** mit zwei von einander isolierten elektrisch leitfähigen Lagen **7** oder auch Leiterlagen dargestellt ist. Die Lagen **7** sind nur entlang einer Längsseite des Substrats **6a** ausgebildet, sie können aber auch um die Kanten des Substrats **6a** herum angeordnet sein.

In **Fig.4b** sind mehrere Substratlagen **6d** auf dem mittleren Substrat **6a** mit zwischengelegten Leiterbahnen bzw. elektrisch leitenden Lagen **7** angeordnet. Diese lassen sich in der Regel als Dickfilmstrukturen auf das Substrat **6a** aufbringen.

**Fig.4c** zeigt ein Substrat **6a** als Trägerelement in der Mitte der Darstellung mit einer aufgebrachten Lage **7.** Beide sind von einem magnetisch leitfähigen Mantel **22,** vorzugsweise aus MnZn oder NiZn-Ferrit umgeben. Der Mantel **22** kann dabei auch abschnittsweise entlang der Längsachse des Verbindungselements **6** vorliegen. Neben dem Mantel kann auch das Substrat 6a aus magnetisch leitfähigem Material bestehen.

In **Fig.4d** hat ein Substrat **'6a** einen Querschnitt, der von den bisher gezeigten, einfach rechteckigen abweicht. Prinzipiell ist der Querschnitt frei wählbar und kann der gewünschten Geometrie ohne weiteres angepasst werden. Der Querschnitt in **Fig.4d** ist U-förmig, wobei die Lagen **7** um das Substrat **6a** herum angeordnet sind. Dabei ist ein Arm der U-Form gerade so lang, dass er einer vorbestimmten Isolierstrecke **a** entspricht, damit eine ausreichende Isolierung zwischen den Lagen und aufgebrachten Bauelementen besteht. Ferner ist an freie Enden des U-förmigen Querschnitts ein Kondensator **6c** angeordnet und mittels Lötverbindungen **17** mit den Lagen **7** elektrisch verbunden. Dabei umschließen der Kondensator **6c** und das Substrat **6a** einen Hohlraum, welcher mit einer Vergussmasse gefüllt sein kann.

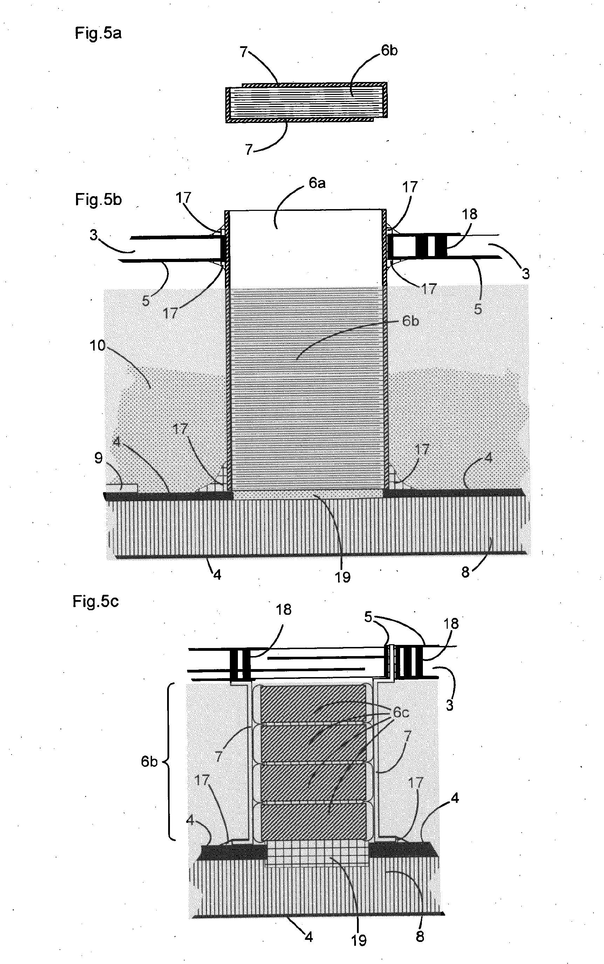

Das Verbindungselement **6** kann anstatt einer Trägerstruktur aus keramischem Substrat auch eine Trägerstruktur aufweisen, die aus einem oder mehreren Kondensatoren, insbesondere Multilagen-Plattenkondensatoren aufgebaut ist. Die **Fig.5a** bis **5c** zeigen dazu mögliche Anordnungen, wobei eine Kondensatorstruktur **6b** eine Trägerstruktur für das Verbindungselement **6** bildet. Die **Fig.5a** zeigt dazu einen Querschnitt eines solchen Verbindungselementes. Die Kondensatorstruktur **6b** kann aus einem keramischen Material, wie z.B. Niedertemperatur-Einbrand-Keramiken (LTCC) oder Hochtemperatur-Mehrlagenkeramik (HTCC) mit metallischen Zwischenlagen aufgebaut sein. Die Herstellung von Mehrschicht-Keramikkondensatoren ist industrieller Standard und kann kostengünstig erfolgen - Keramikkondensatoren der entsprechenden Spannungsklasse können auch als fertige Bauteile kostengünstig eingesetzt werden. Ferner erhöht der Multilagen-Aufbau die Kapazität der Verbindung. Durch diese Kombination von elektrischer Verbindung und elektrischem Energiespeicher entfällt der ansonsten für einen diskreten Kondensator notwendige Platzbedarf auf dem Hauptsubstrat **8.** In Kombination mit den Leitungen (die eine Induktivität aufweisen können) auf dem Modulsubstrat und auf dem übergeordneten Schaltungsträger **3** kann diese Verbindungsstruktur zusätzlich als T-Filter wirken.

Die Lagen **7** sind dabei auf eine Außenhülle der Kondensatorstruktur **6b** aufgebracht. Nach **Fig.5a** sind Platten des Kondensators **6b** parallel zu einer Längsachse des Verbindungselements **6** angeordnet, wobei die Leitfähigkeit der Struktur in Richtung einer verbesserten Stromzuleitung unterstützt wird.

In **Fig.5b** kann das Verbindungselement **6** aus einer Kombination zwischen Substrat **6a** und Kondensatorstruktur **6b** aufgebaut sein. Letztere bildet dabei eine Interdigitalstruktur, deren Platten sich in etwa parallel zum Hauptsubstrat **8** des Leistungselektronikmoduls **2** vorliegen. Dieser Aufbau weist durch die mögliche Vielzahl an Platten eine nochmals geringere Induktivität als der Aufbau nach **Fig.5b****.** auf.

In **Fig.5c** ist die Kondensatorstruktur aus vorgefertigten, kommerziell erhältlichen Bauteilen aufgebaut. Dazu sind mehrere Keramikkondensatoren **6c** zu der Kondensatorstruktur **6b** zusammengesetzt. Die Anschlüsse sind, ev. über zusätzliche elektrische Leiter, sowohl mit den Lagen **4** des Hauptsubstrats **8** wie auch den Lagen **5** des übergeordneten Schaltungsträgers **3** elektrisch verbunden. Die elektrische und mechanische Verbindung zwischen den Kondensatoren **6c** und den Lagen **4, 5** kann über eine Lötnaht **17** erfolgen. Die Zwischenräume zwischen den einzelnen Kondensatoren 6c sowie den Kondensatoren **6c** und dem Hauptsubstrat **8** sind mittels einer Klebung **19** aus einem organischen Material, z.B. einem Epoxidharz vergossen. Dabei können die Kondensatoren **6c,** wie in **Fig.4c** gezeigt, parallel bzw. entlang der Längsachse des Verbindungselements **6** oder auch normal dazu angeordnet sein. Der Platzbedarf dieser zusätzlichen Bauteile kann optimiert werden, wodurch die Integrationsdichte des Leistungselektronikmoduls **2** erhöht wird.

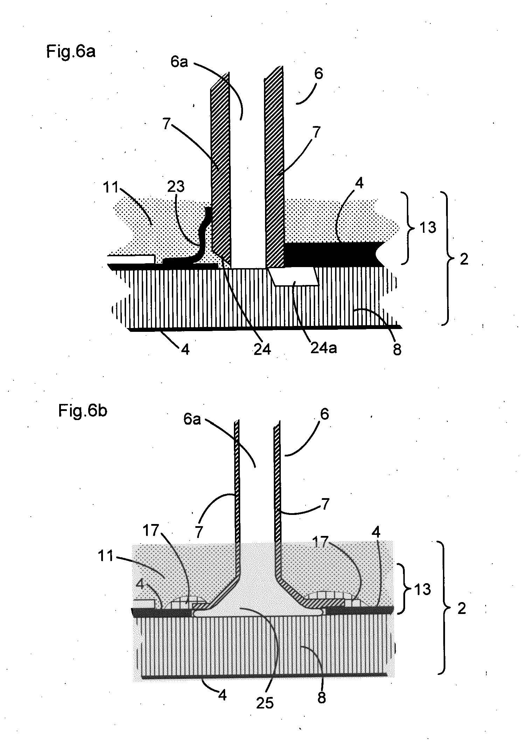

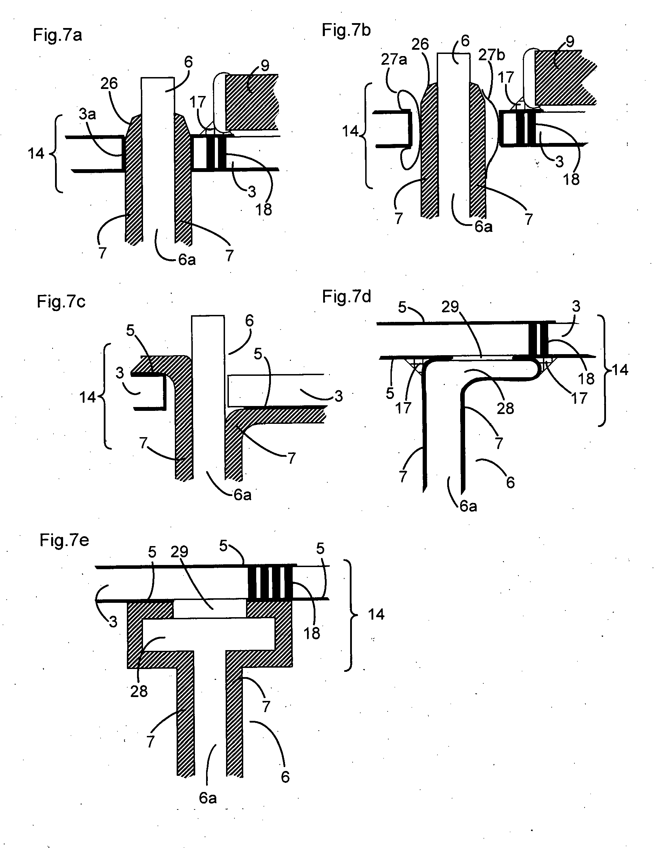

Das Verbindungselement **6** kann mit den Komponenten der Bauteilanordnung **1** über lösbare und nicht lösbare elektrische oder elektromechanische Verbindungen mechanisch und elektrisch verbunden sein, insbesondere durch Löten, dem sogenannten Press-Fit oder mittels Presskontakten. **Fig.6a** bis **6e** zeigen dabei verschiedene Ausgestaltungen einer Verbindung bzw. Befestigungen von Verbindungselement **6** und Leistungselektronikmodul **2 (****Fig.6a** und **6b****).** Mögliche Verbindungen zwischen Verbindungselement **6** und dem übergeordneten Schaltungsträger **3** sind in **Fig.7a** bis **7e** dargestellt.

Neben einem form- oder kraftschlüssigen Verpressen des ersten Befestigungsabschnitts **13** kann, wie in **Fig.6a** dargestellt, das Substrat **8** des Leistungselektronikmoduls **2** keine Vertiefung aufweisen, sondern lediglich einen Bereich ohne Lage aufweisen. Für eine lösbare Verbindung ist am ersten Befestigungsabschnitt **13** die Lage **7** mit einer Abschrägung **24** versehen und die Lage **7** mit der Lage **4** des Leistungselektronikmoduls **2** über eine Zuleitung **23** verbunden. Die Zuleitung **23** kann mit der Lage **7** und der Lage **4** auch nicht lösbar verlötet sein oder als federndes Element zwischen den Lagen ausgeführt sein. Die Abschrägung **24** kann durch spanende Prozesse erfolgen oder - im Fall von Dickschichten - durch stufenförmiges, schichtweises Aufbringen. Für eine haltbare Klebung oder um einen höheren Isolationsschutz zu erreichen, kann das Hauptsubstrat **8** mit einer Vertiefung **24a** versehen sein.

Der erste Befestigungsabschnitt **13** kann nach **Fig.6b** auch als Fuß **25** ausgebildet werden, der zu einer Oberfläche des Substrats **8** verbreitert ist. Die Lagen **7** folgen den Außenkonturen des Fußes **25** und sind über Lötnähte **17** mit den Oberflächenlagen **4** des Substrates elektrisch verbunden. Auf diese Weise wird ein Spalt im Hauptsubstrat **8** vermieden und trotzdem der notwendige Abstand zwischen den verschiedenen elektrischen Potentialen gewahrt. Der Fuß **25** kann in weiteren Ausführungsformen einseitige Abschrägungen oder auch Stufen aufweisen.

Die in **Fig.7a** bis **7e** gezeigten Befestigungen von Verbindungselement **6** mit übergeordnetem Schaltungsträger **3** sind je nach verwendeten Kleber oder Lötmaterialien als unlösbare Verbindungen vorgesehen. Lösbare Verbindungen sind als Presssitz (Press-Fit) oder Steckkontakte möglich, wie bspw. gemäß **Fig.7a****.** Für eine gut sitzende Presssitz-Verbindung ist die Ausbildung einer geätzten Fingerstruktur des Substrats 6a von Vorteil. Ferner sind Abschrägungen **26** an den Lagen **7** vorgesehen, um das Verbindungselement **6** einfacher in die Öffnung 3a zu führen.

Die **Fig.7b** zeigt eine lösbare Steckverbindung. Zur Befestigung ist eine zweiteilige Federeinrichtung vorgesehen, wobei eine erste Feder **27a** fest mit dem übergeordneten Schaltungsträger **3** und eine zweite Feder **27b** fest dem Verbindungselement **6** verbunden ist. Die so herstellbare Verbindung zwischen übergeordnetem Schaltungsträger 3 und Verbindungselement **6** kann im Bedarfsfall gelöst werden und erlaubt, dass eine defekte Komponente der elektronischen Bauteilanordnung **1** ausgetauscht werden kann.

Es können weitere nicht lösbare Verbindungen realisiert werden. Nach **Fig.7c** sind die Lagen **7** des Verbindungselements 6a auf eine Unter- bzw. Oberseite des übergeordneten Schaltungsträgers **3** weitergeführt und die Komponenten damit fest verbunden bzw. verlötet.

In **Fig.7d** und **Fig.7e** sind Befestigungen gezeigt, die ohne einen Durchbruch oder eine Öffnung in dem übergeordneten Schaltungsträger **3** auskommen. Das Substrat 6a des Verbindungselements **6** ist in beiden Figuren als Fuß 28 ausgebildet. In **Fig.7d** ist der Fuß einfach rechtwinklig und bildet mit seiner Stirnseite eine große Anlagefläche an den übergeordneten Schaltungsträger **3.** Die Lagen **7** sind voneinander beabstandet und lassen an der Stirnseite des Fußes **28** eine lagenfreien Abschnitt (Isolationsabstand **29)** frei, der als Kriechstrecke dient. Damit wird trotz eines geringen Abstandes der Lagen **7** zueinander eine elektrische Anbindung an eine Seite des übergeordneten Schaltungsträgers **3** unter Wahrung der notwendigen Kriechstrecke ermöglicht. In **Fig.7e** ist der Fuß T-förmig, womit ein hoher Isolierungsabstand **29** im Bereich zwischen übergeordnetem Schaltungsträger **3** und den Lagen **7** erreicht wird.

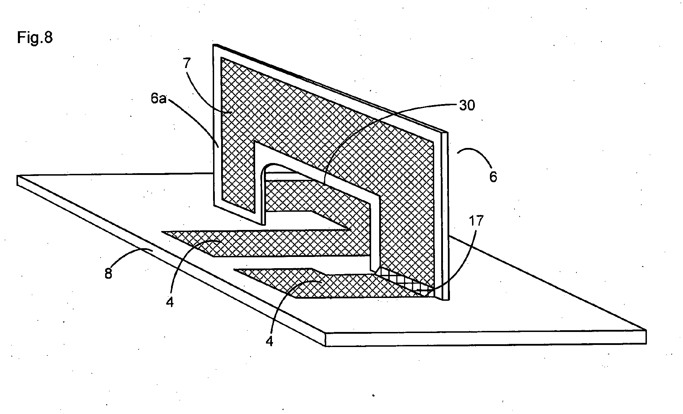

Ein Verbindungselement **6** kann, wie die **Fig.8** darstellt, nicht nur als eine einfache planare Struktur ausgebildet sein, sondern unterschiedlichen Anforderungen gerecht werden, wobei eine Aussparung **30** dazu dienen kann, Abschnitte oder Bereiche mit Leiterbahnen bzw. anderen Bauelementen auf dem Hauptsubstrat **8** des Leistungselektronikmoduls zu überbrücken. Die Aussparung **30** ist im Wesentlichen rechteckig, kann aber beliebig geformt sein, wobei durch die beidseitige Metallisierung, d. h. die elektrisch leitfähigen Lagen **7** des Verbindungselements **6** parasitäre Induktivitäten minimiert und eine zusätzliche Verbindungsebene geschaffen wird.

### Bezugszeichenliste

- 1: Elektronische Bauteilanordnung
- 2: Leistungselektronikmodul
- 3: übergeordneter Schaltungsträger
- 3a: Öffnung
- 4: elektrisch leitende Lage Leistungselektronikmodul
- 5: elektrisch leitende Lage übergeordneter Schaltungsträger
- 6: Verbindungselement
- 6a: Substrat
- 6b: Kondensatorstruktur
- 6c: Kondensator
- 6d: Substratlage
- 7: elektrisch leitende Lage Verbindungselement
- 8: Hauptsubstrat Leistungselektronikmodul
- 9: elektronische Komponenten
- 10: Vergussmasse
- 11: Modulrahmen
- 12: Substrat übergeordneter Schaltungsträger
- 13: erster Befestigungsabschnitt
- 14: zweiter Befestigungsabschnitt
- 15: Ausnehmung/Vertiefung Hauptsubstrat
- 16: Zuleitung
- 17: Lötnähte
- 18: Kontaktierungen
- 19: Klebeverbindung
- 20: Ausnehmung Verbindungselement.
- 21: Halteeinrichtungen Rahmen
- 22: Mantel
- 23: Zuleitung
- 24: Abschrägung
- 25: Fuß

- 26: Abschrägung
- 27a, 27b: Federn
- 28: Fuß
- 29: Isolierungsabstand
- 30: Aussparung

- a: Isolierstrecke
- c1, c2, c3: Abschnitte Kriechstrecke

## Patentansprüche

1. Elektronische Bauteilanordnung **(1)** mit einem Leistungselektronikmodul **(2)** und einem übergeordneten Schaltungsträger **(3),** wobei
das Leistungselektronikmodul **(2)** zumindest eine elektrisch leitende Lage **(4),** und der übergeordnete Schaltungsträger **(3)** zumindest eine elektrisch leitende Lage **(5)** als Oberflächenstruktur aufweisen,
**dadurch gekennzeichnet, dass**
das Leistungselektronikmodul **(2)** und der übergeordnete Schaltungsträger **(3)** durch zumindest ein plattenförmiges Verbindungselement **(6)** miteinander elektrisch und mechanisch verbunden sind, wobei das zumindest eine Verbindungselement **(6)** zumindest eine elektrisch leitende Lage **(7)** als Oberflächenstruktur aufweist, die mit der zumindest einen elektrisch leitenden Lage **(4)** des Leistungselektronikmodus **(2)** und mit der zumindest einen elektrisch leitenden Lage **(5)** des übergeordneten Schaltungsträgers **(3)** elektrisch verbunden ist; und wobei das Verbindungselement **(6)** zumindest einen Kondensator **(6b)** mit einer nicht leitenden Oberfläche aufweist, die die zumindest eine elektrisch leitende Lage **(7)** trägt.

2. Elektronische Bauteilanordnung **(1)** nach Anspruch 1,
**dadurch gekennzeichnet, dass**
ein mehrlagiger Aufbau des Verbindungselements **(6)** auch als integrierter Kondensator **(6b)** dient.

3. Elektronische Bauteilanordnung **(1)** nach Anspruch 1 oder 2,
**dadurch gekennzeichnet, dass**
das Verbindungselement **(6)** mehr als zwei elektrisch leitende Lagen **(7)** aufweist, die voneinander elektrisch isoliert sind.

4. Elektronische Bauteilanordnung **(1)** nach zumindest einem der Ansprüche 1 bis 3,
**dadurch gekennzeichnet, dass**
das Verbindungselement **(6)**
- zumindest eine Lage aus einem Substrat **(6a)** aufweist, bevorzugt aus einer Lage aus einem organischen oder keramischen Substrat **(6a),** wobei die Lage mit einem magnetisch leitfähigen Material, bevorzugt aus MnZn oder NiZn-Ferrit abschnittsweise/teilweise oder vollständig ummantelt ist, oder
- zwei oder mehrere Lagen aus einem Substrat **(6a)** aufweist, bevorzugt aus Lagen aus einem organischen oder keramischen Substrat **(6a),** wobei zwischen zumindest zwei der zwei oder mehreren Lagen eine elektrisch leitfähige Lage **(7),** bevorzugt eine Metalllage angeordnet ist.

5. Elektronische Bauteilanordnung **(1)** nach zumindest einem der Ansprüche 1 bis 4,
**dadurch gekennzeichnet, dass**
- die zumindest eine elektrisch leitende Lage **(7)** des Leistungselektronikmoduls **(2)** und/oder die auf einem Hauptsubstrat **(8)** des Leistungselektronikmoduls **(2)** angeordneten elektronischen Komponenten **(9)** ganz oder teilweise in eine Vergussmasse **(10)** eingegossen sind, wobei ein Abschnitt des Verbindungselements **(6)** aus der Vergussmasse **(10)** herausragt, und/oder
- das zumindest eine Substrat **(6a)** des Verbindungselementes **(6)** zumindest eine Aussparung **(30)** aufweist, die entlang einer Längsrichtung des Leistungselektronikmoduls **(2)** und/oder in Richtung des übergeordneten Schaltungsträgers **(3)** angeordnet ist.

6. Elektronische Bauteilanordnung **(1)** nach zumindest einem der Ansprüche 1 bis 5,
**dadurch gekennzeichnet, dass**
das Verbindungselement **(6)** durch Kleben, Löten oder Verpressen mit dem Leistungselektronikmodul **(2)** unlösbar verbunden ist, und/oder
das Verbindungselement **(6)** mit dem übergeordneter Schaltungsträger **(3)** durch flexible Verbindungselemente lösbar oder durch Kleben, Löten oder Verpressen unlösbar verbunden ist.

7. Elektronische Bauteilanordnung **(1)** nach Anspruch 6,
**dadurch gekennzeichnet, dass**
der übergeordnete Schaltungsträger **(3)** eine Öffnung **(3a)** aufweist, durch die ein zweiter Befestigungsabschnitt **(14)** des Verbindungselements **(6)** ragt und mit den Rändern der Öffnung **(3a)** verbunden ist.

8. Elektronische Bauteilanordnung **(1)** nach zumindest einem der Ansprüche 1 bis 7,
**dadurch gekennzeichnet, dass**
das Leistungselektronikmodul **(2)** ein Hauptsubstrat **(8)** aufweist, das ein planares Keramiksubstrat **(8)** ist, wobei die elektrisch leitende Lage **(4)** bevorzugt eine Dickfilmlage **(4)** ist, und/oder
das Leistungselektronikmodul **(2)** eine Ausnehmung **(15)** aufweist, in der ein erster Befestigungsabschnitt **(13)** des Verbindungselements **(6)** aufnehmbar ist.

9. Elektronische Bauteilanordnung **(1)** nach Anspruch 7 oder 8,
**dadurch gekennzeichnet, dass**
das Verbindungselement **(6)** beidenends zumindest jeweils einen lagenfreien Abschnitt aufweist.

10. Elektronische Bauteilanordnung **(1)** nach zumindest einem der Ansprüche 1 bis 9,
**dadurch gekennzeichnet, dass**
die elektronische Bauteilanordnung **(1)** einen Rahmen **(11)** aufweist, der zumindest eine der Komponenten Leistungselektronikmodul **(2)** und übergeordneter Schaltungsträger **(3)** einrahmt, wobei der Rahmen **(11)** an seiner den zu umrahmenden Komponenten zugewandten Innenseite Halteeinrichtungen **(21)** aufweist, mit denen das Leistungselektronikmodul **(2)** und/oder der übergeordnete Schaltungsträger **(3)** und/oder das Verbindungselement **(6)** in Eingriff steht, wobei die Halteeinrichtungen **(21)** insbesondere Ausnehmungen oder Überstände sind.

11. Elektronische Bauteilanordnung **(1)** nach zumindest einem der Ansprüche 1 bis 10,
**dadurch gekennzeichnet, dass**
das plattenförmige Verbindungselement **(6)** mit seiner Normalen senkrecht zur Normalen des Leistungselektronikmoduls **(2)** angeordnet ist.
